Europäisches Patentamt

European Patent Office

Office européen des brevets

(11) Publication number: **0 262 860**
**A2**

## (12) EUROPEAN PATENT APPLICATION

(21) Application number: **87308412.3**

(22) Date of filing: **23.09.87**

(51) Int. Cl.⁴: **G01R 31/00 , H04B 3/46**

(30) Priority: **01.10.86 US 914725**

(43) Date of publication of application:
**06.04.88 Bulletin 88/14**

(84) Designated Contracting States:
**DE FR GB**

(71) Applicant: **AMERICAN TELEPHONE AND TELEGRAPH COMPANY**
**550 Madison Avenue**
**New York, NY 10022(US)**

(72) Inventor: **Fuller, Richard Clair**
**36 Elmwood Lane**
**Fair Haven New Jersey 07701(US)**

(74) Representative: **Johnston, Kenneth Graham et al**
**Western Electric Company Limited 5 Mornington Road**
**Woodford Green Essex, IG8 OTU(GB)**

(54) **Digital signal analysis by transformation to vector domain.**

(57) A method (10) for digital measurement of analog parameters includes the steps of generating a test signal (12) in the circuit under test, transforming (14) that signal into an analytic signal in the vector domain, and then demodulating the analytic signal into its natural components, envelope, and phase in a process common to the evaluation of all circuit parameters. The frequency, phase jitter, transient measurements, signal level, noise, and envelope delay distortion are then evaluated in separate routines by analysis of, or calculation with, the components of the analytic signal. These analog parameters are all measured in the digital domain by means of a digital signal processor.

FIG. 1

## DIGITAL SIGNAL ANALYSIS BY TRANSFORMATION TO VECTOR DOMAIN

### Technical Field

This invention relates to the testing of telecommunication circuits, especially those in the voiceband range of 0-4 KHz, such as trunk lines and special service circuits.

### Background of the Invention

The condition of a particular circuit may be evaluated by examining a test signal sample for certain circuit parameters, such as frequency, level, and noise, for information about the equipment and lines in the circuit. The measurement of these parameters has previously been done largely through analog circuitry. This type of measurement may be done in either the time or the frequency domain, typically through filtering or other types of discrimination techniques. Such processing tends to be slow, with poor accuracy, and has other problems typical of analog processing associated with it. The advantages of digital signal processing have been sought in performing the measurements. Recently, some of the more basic measurements have been made through digital signal processing using Fourier transform or other discrimination techniques, but many of the parameters are still required to be evaluated through analog processing.

### Summary of the Invention

The present invention is a method and apparatus for measuring circuit parameters through digital signal processing of an analytic signal obtained by the transformation of an analog test signal sample to the vector domain. Vector demodulation of the analytic signal is then performed for evaluating the parameters. First, the signal is broken down into its natural components, envelope and phase, in a process common to the evaluation of all circuit parameters. Then, these components are processed to evaluate each parameter.

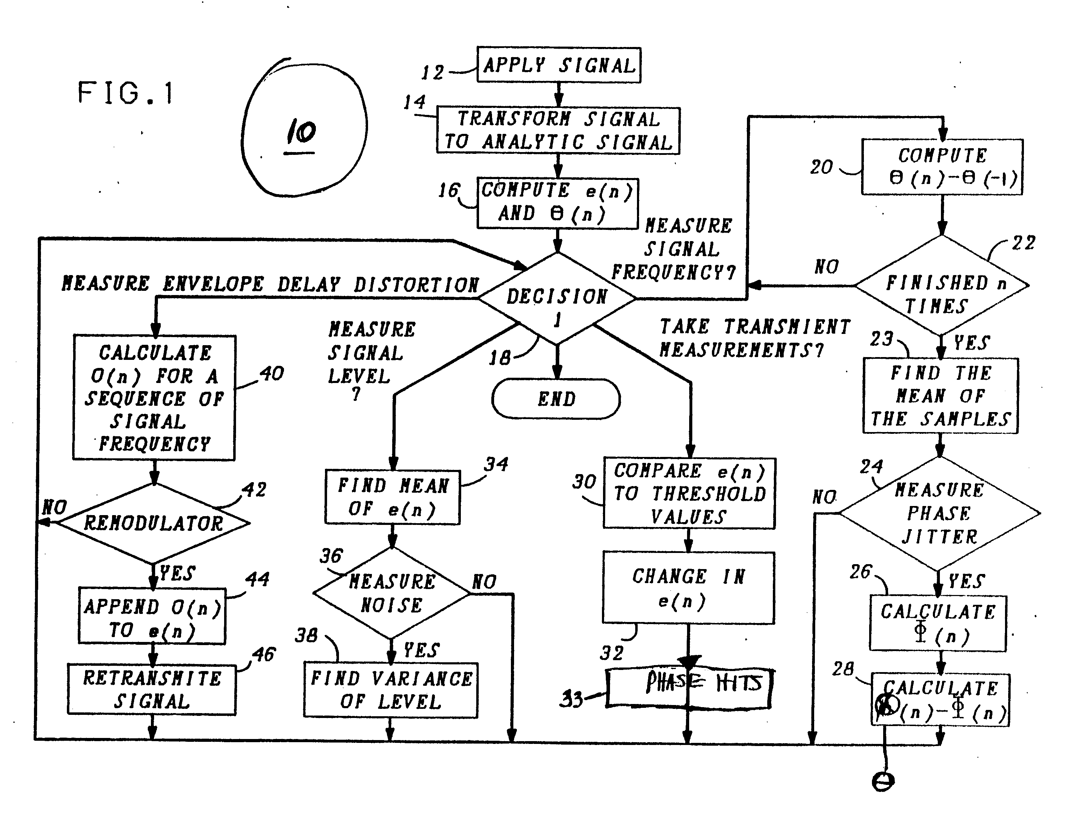

### Brief Description of the Drawing

The figure is a flowchart which illustrates the mode of operation of an apparatus in accordance with the present invention.

### Detailed Description

A signal measurement apparatus in accordance with the present invention may be implemented by appropriately programming a DSP device of the type generally available to execute the algorithm described below. One device which is suitable for such implementation is the model DSP 12 marketed by AT&T Co., a corporation of New York, U.S.A., and described, for example, in The Bell System Technical Journal,Vol. 60, No.7, Part 2, September,1981. The implementation of the invention would generally require programming which is specific for the particular DSP chosen, but would be readily performable by a person knowledgeable in the art of digital signal processor implementations who is provided with the required algorithm.

Referring to the figure, there is shown a functional diagram 10, in flowchart form, of an algorithm for the operation of a system in accordance with the present invention for analog measurement in the digital domain by analysis of an analytic signal. Although strictly speaking, a discrete signal cannot be analytic, the analogy with an analog analytic signal is considered close enough to make such terminology meaningful and appropriate. The mode of operation of the measurement system which has the means for evaluating the circuit parameters is also illustrated by the diagram 10. The algorithm includes a front-end process common to the procedure for evaluation of all circuit parameters and includes the evaluation processes for each of the parameters.

As indicated in the diagram 10, in step 12 a test signal is applied to the circuit under test. The signal is then sampled and transformed in step 14 into its corresponding vector domain analytic signal. The analytic signal can be represented by

(1) $a(n) = e(n)\exp[j\theta(n)]$

where $a(n)$ represents the analytic signal, $e(n)$ represents its envelope or magnitude, $\theta(n)$ represents its phase, and exp represents the base of the natural logarithm. The generation of this analytic signal can be accomplished through a Hilbert transform by way of a suitable Finite Impulse Response (FIR) filter with complex coefficients. In step 16 reduction of the analytic signal into its envelope and phase is performed. The envelope can be evaluated as

(2) $e(n) = \{[a(n)^*a^*(n)]\}^{1/2}$

and the phase can be evaluated as

(3) $\theta(n) = \ln[a(n)/e(n)]/j$

These three steps complete the front-end process common to the evaluation of all the circuit parameters.

2. The method of claim 1, further CHARACTERIZED BY

after said envelope evaluating, evaluating at least one parameter for said circuit chosen from the group consisting of the level, the envelope delay, the distortion, and the phase of said test signal.

3. The method of claim 2, further CHARACTERIZED BY

evaluating the level by calculating the mean of said envelope.

4. The method of claim 2, further CHARACTERIZED BY

evaluating the envelope delay distortion in the envelope of the analytic signal by extraction of the phase of the envelope modulation for a sequence of test carrier signal frequencies.

5. The method of claim 2, further CHARACTERIZED BY

remodulating the envelope delay distortion signal by appending said envelope to a generated carrier.

6. The method of claim 2, further CHARACTERIZED BY

evaluating the phase of said test signal from the analytic signal and the envelope.

7. The method of claim 3, further CHARACTERIZED BY

after said level evaluating, evaluating the noise of said test signal by finding the variance in said level.

8. The method of claim 7, further CHARACTERIZED BY

after said phase evaluating, evaluating at least one parameter chosen from the group consisting of the phase jitter, the frequency, and the transient measurements.

9. The method of claim 8, further CHARACTERIZED BY

evaluating the frequency of said test signal, on a per sample basis, by calculating the difference between the phase of the present sample and the phase of the previous sample.

10. The method of claim 9, further CHARACTERIZED BY

after said frequency evaluating, evaluating the phase jitter on a per sample basis by calculating the difference between the phase of the test signal and a discrete function calculated from a frequency obtained by a long average of the frequency samples of said test signal.

11. The method of claim 8, further CHARACTERIZED BY

evaluating the transients by:

detecting dropouts by comparing the envelope samples to a threshold value;

detecting gain hits by finding rapid changes in envelope samples; and,

detecting phase hits by finding rapid changes in phase samples.

12. A measurement system for evaluating, in the digital domain, the parameters of a circuit CHARACTERIZED BY

means for generating a test signal in the circuit;

means for transforming said test signal into an analytic signal in the vector domain; and

means for evaluating the envelope of said test signal from said analytic signal.

The measurement system of claim 12, further CHARACTERIZED BY

means for evaluating the level of said test signal by calculating the mean of said envelope.

14. The measurement system of claim 13, further CHARACTERIZED BY

means for evaluating the noise of said test signal by finding the variance of said level.

15. The measurement system of claim 12, further CHARACTERIZED BY

means for evaluating the envelope delay distortion by extracting the phase of the envelope modulation from the analytic signal for a sequence of test signal frequencies.

16. The measurement system of claim 12, further CHARACTERIZED BY

means for remodulating the signal by appending said envelope to a carrier of one of the test frequencies and retransmitting the resulting signal.

17. The measurement system of claim 12, further CHARACTERIZED BY

means for evaluating the phase of said test signal from the analytic signal and the envelope.

18. The measurement system of claim 17, further CHARACTERIZED BY

means for evaluating the frequency of said test signal on a per sample basis by calculating the difference between the phase of the present sample and the phase of the previous sample.

19. The measurement system of claim 18, further CHARACTERIZED BY

means for evaluating the phase jitter on a per sample basis by calculating the difference between the phase of the test signal and a discrete function calculated from a frequency obtained from a long average of the frequency samples of the test signal.

20. The measurement system of claim 15, further CHARACTERIZED BY

At this point measurement, there is a decision to be made at step 18. If the signal frequency is to be measured, then the algorithm proceeds to step 20, where the frequency is evaluated on a per sample basis, as $\theta(n) - \theta(n-1)$. Step 20 is repeated n times, for n frequency samples, as indicated in step 22. As indicated in step 23, the mean of the frequency samples is the signal frequency. When step 24 is reached, if the phase jitter is not to be measured, the algorithm returns to step 18. If the phase jitter is to be measured, the algorithm proceeds to step 26. Steps 26 and 28 illustrate a new algorithm for measuring phase jitter (phase disturbances) by which the true phase jitter is obtained, rather than that inferred from the zero crossings of a tone. First, in step 26, $\Phi(n)$ is calculated. $\Phi(n)$ is a phase calculated by using a frequency obtained by a long average of the signal frequency. Then, in step 28, the phase jitter Jtr(n) is calculated. It can be represented by

(4) $Jtr(n) = \theta(n) - \Phi(n)$.

Traditional phase jitter measurements inferred phase disturbances from the zero crossings of a tone. The present algorithm of phase jitter measurement speeds up the measurement over conventional zero crossing measurement methods. This is due to the fact that every sample of the holding tone is used in the jitter computation, not just the zero crossing values. After the calculation of the phase jitter, the algorithm returns to step 18.

If, when the algorithm reaches step 18, transient measurements are to be taken, the algorithm proceeds to step 30. Transient measurements detect abrupt changes in amplitude or phase which occur at infrequent intervals. These changes are detected by testing for dropouts (loss of signal carrier), gain hits (rapid gain changes), and phase hits (rapid phase changes). In step 30, dropouts are measured by comparing e(n) to a specified threshold value. In step 32, gain hits are evaluated by checking for rapid changes in e(n) samples. In step 33, phase hits are identified by checking for rapid changes in samples of $\theta(n)$. After calculation of the gain hits, phase hits, and dropouts, the algorithm returns to step 18.

If the signal level is to be measured, the algorithm proceeds to step 34. The level follows directly from the envelope, e(n). To find the level, the mean of the envelope samples is found. At step 36, if the noise is not to be found, the algorithm returns to step 18. If the noise is to be measured, the variance of the level is found in step 38 by comparing actual envelope samples to the level. After the noise has been found, the algorithm returns to step 18.

Once measurements such as frequency, level, and noise have been made, the measurement parameters are evaluated to indicate the quality of the measured signal. These parameters can be used to assure that the signal level meets a certain threshold level, that the statistics of the received signal don't change significantly during the measurement period, and that the signal-to-noise ratio is significantly high to indicate high measurement accuracy.

Envelope delay is a measure of the signal dispersion, which can impair symbol transmission in analog data transmission. If the distortion due to this delay is to be measured, the algorithm proceeds to step 40. As indicated in step 40, envelope delay distortion measurement is the extraction of the phase, O, of the test signal amplitude modulation for a sequence of carrier frequencies. Synchronous demodulation is used to obtain this phase. Noise immunity is obtained by averaging the phase over a sequence of projections. An important aspect of this approach is the capability it provides to measure the frequency of the carrier on a per-sample basis. Since the phase of the analytic signal is the phase of the carrier, its sample-to-sample difference is directly related to the carrier frequency.

For envelope delay distortion measurement, is is generally necessary to provide remodulation capability. If that is the case, then the algorithm proceeds to step 44. As indicated in step 44, remodulation is provided by appending to the envelope of the analytic signal the appropriate phase and, as indicated in step 46, retransmitting the resulting signal to the original carrier. After evaluation of the envelope delay distortion the algorithm returns to step 18.

If at step 18 there are no additional measurements to be made, the process ends.

Although the invention can be conveniently implemented by a digital signal processor, the algorithm can also be carried out by any general purpose device that has the appropriate capabilities for digital signal processing and for executing the algorithm.

**Claims**

1. A method for evaluating, in the digital domain, the parameters of a circuit,
CHARACTERIZED BY
generating a test signal in the circuit; then
transforming said test signal into an analytic signal in the vector domain; and then
evaluating the envelope of said test signal from said analytic signal.

means for detecting dropouts by comparing the envelope samples to a threshold value;

means for detecting gain hits by finding rapid changes in envelope samples; and

means for detecting phase hits by finding rapid changes in phase samples.

FIG.1

10

12 APPLY SIGNAL

14 TRANSFORM SIGNAL TO ANALYTIC SIGNAL

16 COMPUTE e(n) AND θ(n)

20 COMPUTE θ(n)−θ(−1)

MEASURE SIGNAL FREQUENCY?

22 FINISHED n TIMES — NO

MEASURE ENVELOPE DELAY DISTORTION

DECISION 1

18 END

MEASURE SIGNAL LEVEL ?

TAKE TRANSMIENT MEASUREMENTS?

23 FIND THE MEAN OF THE SAMPLES — YES

40 CALCULATE O(n) FOR A SEQUENCE OF SIGNAL FREQUENCY

34 FIND MEAN OF e(n)

30 COMPARE e(n) TO THRESHOLD VALUES

24 MEASURE PHASE JITTER — NO

42 REMODULATOR — NO

36 MEASURE NOISE — NO

CHANGE IN e(n)

26 CALCULATE Φ(n)

44 APPEND O(n) TO e(n) — YES

38 FIND VARIANCE OF LEVEL — YES

32

33 PHASE HITS

28 CALCULATE Φ(n)−Φ(n)

46 RETRANSMITE SIGNAL

0 262 860